# EUROPEAN PATENT APPLICATION

(11) **EP 4 346 341 A1**
(43) Date of publication of application: **03.04.2024**
(21) Application number: 22198598.9
(22) Date of filing: 29.09.2022
(51) Int. Cl.: H05K 3/34, H05K 3/32, H05K 1/03

(54) **METHOD FOR FORMING A POWER SEMICONDUCTOR MODULE ARRANGEMENT**

(71) Applicant: Infineon Technologies AG, 85579 Neubiberg (DE)
(72) Inventor: BAYER, Christoph, 97320 Albertshofen (DE); HOHLFELD, Olaf, 59581 Warstein (DE)
(74) Representative: Westphal, Mussgnug & Partner, Patentanwälte mbB

(57) **Abstract**

A method comprises applying a soldering or sintering pre-layer (32) to a substrate (10), arranging a passive component (22) on the soldering or sintering pre-layer (32), and directing a laser beam (80) to the soldering or sintering pre-layer (32), thereby heating the soldering or sintering pre-layer (32).

## Description

### TECHNICAL FIELD

The instant disclosure relates to a method for forming a semiconductor module arrangement, in particular to a method for mounting passive components to a substrate of a power semiconductor module arrangement.

### BACKGROUND

Power semiconductor module arrangements often include at least one semiconductor substrate arranged in a housing. A semiconductor arrangement including a plurality of controllable semiconductor elements (e.g., IGBTs, MOSFETs, JFETs, or HEMTs) as well as one or more passive components (e.g., resistors, capacitors, or shunts) is arranged on each of the at least one substrate. Each substrate usually comprises a substrate layer (e.g., a ceramic layer), a first metallization layer deposited on a first side of the substrate layer and a second metallization layer deposited on a second side of the substrate layer. The controllable semiconductor elements and the passive components are mounted, for example, on the first metallization layer. The second metallization layer may optionally be attached to a base plate.

Mounting the one or more passive components to the substrate can be challenging. Oxygen contained in solder or sinter pastes, during conventional soldering or sintering processes, may react with hydrogen that is often present in a processing chamber when performing the soldering or sintering process, which may damage or even destroy the passive components. In addition, a thermal mass of certain passive components such as, e.g., resistors, may cause problems during a conventional soldering or sintering process. Further problems may arise from differences in height of different passive components, for example.

There is a need for an improved method for forming a power semiconductor module arrangement comprising one or more passive components that avoids the drawbacks mentioned above.

### SUMMARY

A method includes applying a soldering or sintering pre-layer to a substrate, arranging a passive component on the soldering or sintering pre-layer, and directing a laser beam to the soldering or sintering pre-layer, thereby heating the soldering or sintering pre-layer.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is a cross-sectional view of a power semiconductor module arrangement.
Figure 2 schematically illustrates a passive component that is being mounted to a substrate.
Figure 3 schematically illustrates another passive component that is being mounted to a substrate.
Figure 4 schematically illustrates an even further passive component that is being mounted to a substrate.
Figure 5, including Figures 5A, 5B and 5C, schematically illustrates a method according to one example.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description, as well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element". An electrical line or electrical connection as described herein may be a single electrically conductive element, or include at least two individual electrically conductive elements connected in series and/or parallel. Electrical lines and electrical connections may include metal and/or semiconductor material, and may be permanently electrically conductive (i.e., non-switchable). A semiconductor body as described herein may be made from (doped) semiconductor material and may be a semiconductor chip or be included in a semiconductor chip. A semiconductor body has electrically connecting pads and includes at least one semiconductor element with electrodes.

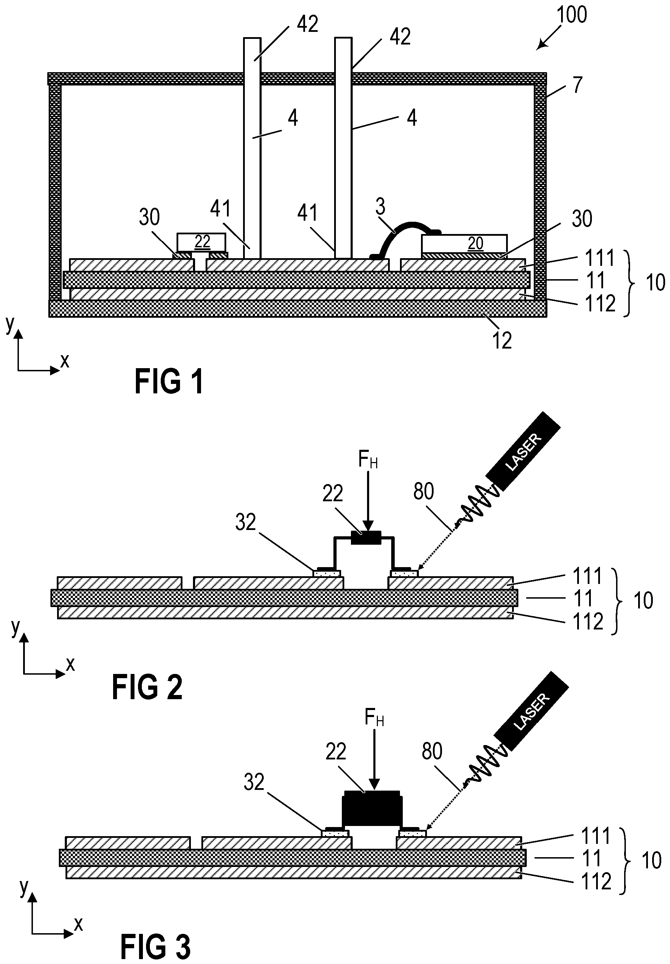

Referring to Figure 1, a cross-sectional view of a power semiconductor module arrangement 100 is schematically illustrated. The power semiconductor module arrangement 100 includes a housing 7 and a substrate 10. The substrate 10 includes a dielectric insulation layer 11, a (structured) first metallization layer 111 attached to the dielectric insulation layer 11, and a (structured) second metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminum; an aluminum alloy; any other metal or alloy that remains solid during the operation of the power semiconductor module arrangement. The substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. For example, the dielectric insulation layer 11 may consist of or include one of the following materials: Al₂O₃, AlN, SiC, BeO or Si₃N₄. For instance, the substrate 10 may, e.g., be a Direct Copper Bonding (DCB) substrate, a Direct Aluminum Bonding (DAB) substrate, or an Active Metal Brazing (AMB) substrate. Further, the substrate 10 may be an Insulated Metal Substrate (IMS). An Insulated Metal Substrate generally comprises a dielectric insulation layer 11 comprising (filled) materials such as epoxy resin or polyimide, for example. The material of the dielectric insulation layer 11 may be filled with ceramic particles, for example. Such particles may comprise, e.g., SiO₂, Al₂O₃, AlN, or BN and may have a diameter of between about 1µm and about 50µm. The substrate 10 may also be a conventional printed circuit board (PCB) having a non-ceramic dielectric insulation layer 11. For instance, a non-ceramic dielectric insulation layer 11 may consist of or include a cured resin.

The substrate 10 is arranged in a housing 7. In the example illustrated in Figure 1, the substrate 10 is arranged on a base plate 12 which forms a ground surface of the housing 7, while the housing 7 itself solely comprises sidewalls and a cover. This is, however, only an example. It is also possible that the housing 7 further comprises a ground surface and the substrate 10 and the base plate 12 be arranged inside the housing 7. In some power semiconductor module arrangements 100, more than one substrate 10 is arranged on a single base plate 12 or on the ground surface of a housing 7. According to another example, the base plate 12 may also be omitted and the substrate 10 itself may form a ground surface of the housing 7.

One or more semiconductor bodies 20 may be arranged on the at least one substrate 10. Each of the semiconductor bodies 20 arranged on the at least one substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), and/or any other suitable semiconductor element. In addition to the one or more semiconductor bodies 20, one or more passive components 22 may also be arranged on the at least one substrate 10. Each of the passive components 22 arranged on the at least one substrate 10 may include a resistor, a capacitor, a shunt, an inductor, and/or any other suitable passive component. The one or more semiconductor bodies 20 together with the one or more passive components 22 may form a semiconductor arrangement on the substrate 10. In Figure 1, only one semiconductor body 20 and one passive component 22 are exemplarily illustrated.

The second metallization layer 112 of the substrate 10 in Figure 1 is a continuous layer. The first metallization layer 111 is a structured layer in the example illustrated in Figure 1. "Structured layer" means that the first metallization layer 111 is not a continuous layer, but includes recesses between different sections of the layer. Such recesses are schematically illustrated in Figure 1. The first metallization layer 111 in this example includes three different sections. This, however, is only an example. Any other number of sections is possible. Different semiconductor bodies 20 and passive components 22 may be mounted to the same or to different sections of the first metallization layer 111. Different sections of the first metallization layer 111 may have no electrical connection or may be electrically connected to one or more other sections using electrical connections 3 such as, e.g., bonding wires. Electrical connections 3 may also include connection plates or conductor rails, for example, to name just a few examples. The one or more semiconductor bodies 20 and the one or more passive components 22 may be electrically and mechanically connected to the substrate 10 by one or more electrically conductive connection layers 30. Such electrically conductive connection layers 30 may be solder layers, layers of an electrically conductive adhesive, or layers of a sintered metal powder, e.g., a sintered silver powder, for example.

According to other examples, it is also possible that the second metallization layer 112 is a structured layer. It is further possible to omit the second metallization layer 112 altogether. It is generally also possible that the first metallization layer 111 is a continuous layer, for example.

The power semiconductor module arrangement 100 illustrated in Figure 1 further includes terminal elements 4. The terminal elements 4 are electrically connected to the first metallization layer 111 and provide an electrical connection between the inside and the outside of the housing 7. The terminal elements 4 may be electrically connected to the first metallization layer 111 with a first end 41, while a second end 42 of each of the terminal elements 4 protrudes out of the housing 7. The terminal elements 4 may be electrically contacted from the outside at their respective second ends 42. A first part of the terminal elements 4 may extend through the inside of the housing 7 in a vertical direction y. The vertical direction y is a direction perpendicular to a top surface of the substrate 10, wherein the top surface of the substrate 10 is a surface on which the at least one semiconductor body 20 and the at least one passive component 22 are mounted. The terminal elements 4 illustrated in Figure 1, however, are only examples. Terminal elements 4 may be implemented in any other way and may be arranged anywhere within the housing 7. For example, one or more terminal elements 4 may be arranged close to or adjacent to the sidewalls of the housing 7. Terminal elements 4 could also protrude through the sidewalls of the housing 7 instead of through the cover. The first end 41 of a terminal element 4 may be electrically and mechanically connected to the substrate 10 by an electrically conductive connection layer, for example (not explicitly illustrated in Figure 1). Such an electrically conductive connection layer may be a solder layer, a layer of an electrically conductive adhesive, or a layer of a sintered metal powder, e.g., a sintered silver (Ag) powder, for example. The first end 41 of a terminal element 4 may also be electrically coupled to the substrate 10 via one or more electrical connections 3, for example. For example, the second ends 42 of the terminal elements 4 may be connected to a printed circuit board (not illustrated in Figure 1).

As has been described above, the one or more semiconductor bodies 20 may be electrically and mechanically connected to the substrate 10 by an electrically conductive connection layer 30, such as a solder layer, a layer of an electrically conductive adhesive, or a layer of a sintered metal powder, e.g., a sintered silver powder, for example. That is, the semiconductor bodies 20 may be attached to the substrate 10 using conventional soldering or sintering techniques, for example. Mounting the one or more passive components 22 to the substrate 10 by means of the same techniques as the one or more semiconductor bodies 20 may be challenging. Oxygen contained in thick solder pastes may react with hydrogen that is often present in a processing chamber during soldering or sintering processes, which may damage or even destroy the passive components. Further, a thermal mass of certain passive components such as, e.g., resistors, may cause problems during a soldering or sintering process. Further problems may arise from differences in height of different passive components, for example.

Therefore, according to one example, the one or more passive components 22 are mounted to the substrate by means of laser sintering or laser soldering techniques. This is schematically illustrated in Figure 2. In particular, Figure 2 schematically illustrates a cross-sectional view of a substrate 10 and a shunt 22 being mounted thereto. In the example illustrated in Figure 2, a first terminal contact of the shunt 22 is arranged on a first section of the first metallization layer 111, and a second terminal contact of the shunt 22 is arranged on a second section of the first metallization layer 112. A soldering or sintering pre-layer 32 is arranged between each of the terminal contacts and the respective section of the first metallization layer 111. The soldering or sintering pre-layer 32 may be formed by applying, e.g., a soldering or sintering paste or powder, or a solder or sinter preform to the first metallization layer 111. A solder or sinter material may be applied to the first metallization layer 111 in any suitable form (e.g., powdery, liquid, viscous or solid) to form the soldering or sintering pre-layer 32. The soldering or sintering pre-layer 32 may comprise or consist of silver, copper, zinc, a silver alloy, a copper alloy, or a zinc alloy, for example. The individual particles of a soldering or sintering powder may have any suitable form and size.

A laser beam 80 is pointed at the soldering or sintering pre-layer 32. By means of the laser beam 80, energy is introduced into the soldering or sintering pre-layer 32 very precisely and selectively. The soldering or sintering pre-layer 32 heats up due to the energy introduced by the laser beam 80. The soldering or sintering pre-layer 32 may be heated up to a required soldering or sintering temperature at which a permanent connection between the shunt 22 and the substrate 10 can be formed. At the required soldering or sintering temperature, the soldering or sintering pre-layer 32 softens or even melts. The specific soldering or sintering temperature generally depends on the material of the soldering or sintering pre-layer 32, as different materials have different softening and melting points.

The shunt 22 has a certain weight which causes the shunt 22 to sink into the softened or melted soldering or sintering pre-layer 32 to a certain degree. When the softened or melted soldering or sintering pre-layer 32 subsequently cools down again (e.g., to room temperature), a permanent connection (electrically conductive connection layer 30) forms between the shunt 22 and the substrate 10. The weight of the passive component 22 itself may be sufficient for the passive component 22 to sink into the softened or melted soldering or sintering pre-layer 32 towards the substrate 10 far enough to ensure that a permanent connection forms between the passive component 22 and the substrate 10. It is, however, also possible, that the passive component 22 is being held in a desired position by a suitable holding mechanism (not specifically illustrated) while performing the laser soldering or laser sintering process. In this way, the passive component 22 can be prevented from unintentionally shifting out of place during the laser soldering or laser sintering process. Further, a certain force F_{H} may be applied on the passive component 22 by such a holding mechanism. This force F_{H} may cause the passive component 22 to sink into the softened or melted soldering or sintering pre-layer 32 towards the substrate 10 even further. The force F_{H}, however, is optional, and is not necessarily required for performing the laser soldering or sintering process.

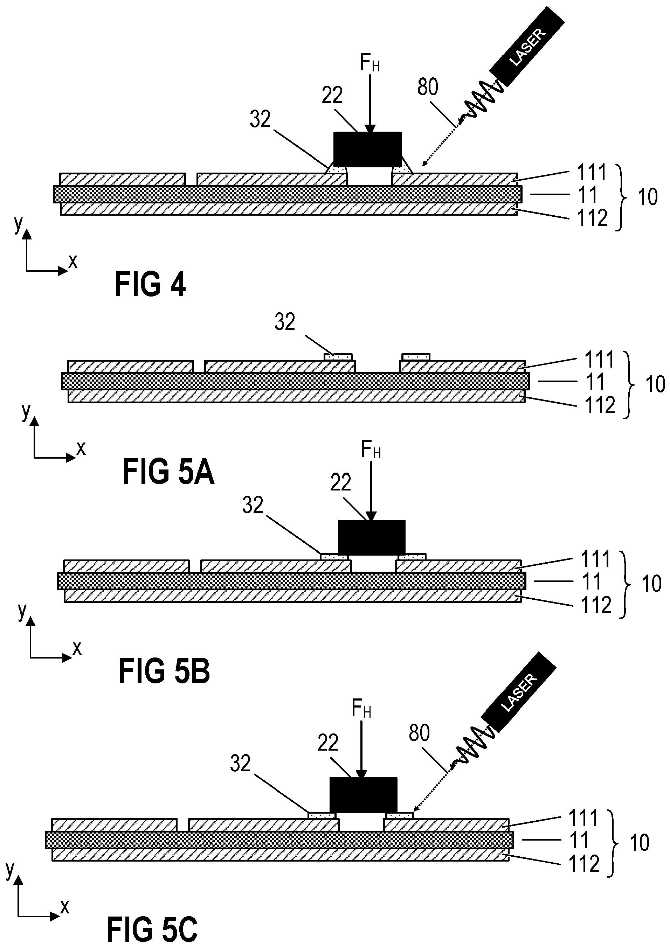

As has been described above, a passive component 22 can be a shunt, as is schematically illustrated in Figure 2. According other examples, a passive component 22 can comprise a capacitor (see Figure 3), or a resistor (see Figure 4), for example. Any other passive components not specifically illustrated herein can also be mounted to a substrate 10 by means of a laser soldering or sintering process. The laser soldering or sintering process that has been described by means of the example of a shunt with regard to Figure 2 above, can equally be performed for any other kind of passive component.

A method according to one embodiment of the disclosure is schematically illustrated in Figure 5. As is illustrated in Figure 5A, in a first step a soldering or sintering pre-layer 32 is applied to a substrate 10. In a following step, a passive component 22 is arranged on the soldering or sintering pre-layer 32 (see Figure 5B). If, for example, a solder or sinter preform is used to form the soldering or sintering pre-layer 32, an adhesion promoter may be applied to the solder or sinter preform before arranging the passive component 22 thereon. Using an adhesion promoter, however, is optional. Now referring to Figure 5C, a laser beam 80 is then directed to the soldering or sintering pre-layer 32, thereby heating the soldering or sintering pre-layer 32. Applying the soldering or sintering pre-layer 32 may comprise applying different sections of the soldering or sintering pre-layer 32 on at least two dedicated connection areas of the substrate 10, wherein the at least two dedicated connection areas are separate and distinct from each other. That is, not the entire surface of the substrate 10 is covered by the soldering or sintering pre-layer 32. The soldering or sintering pre-layer 32 is only applied on dedicated sections (connection areas) of the substrate 10 on which the passive component 22 is to be mounted. In particular, a separate section of a soldering or sintering pre-layer 32 may be arranged between the substrate 10 and each of one and more terminal contacts of the respective passive component 22. As has been described above, a passive component 22 may comprise one or more terminal contacts that are to be electrically connected to the first metallization layer 111 of a substrate 10, for example. According to one example, each of a plurality of terminal contacts is electrically connected to a different section of the first metallization layer 111. A first connection area, therefore, may be arranged on a first section of the first metallization layer 111, while a second connection area may be arranged on a second section of the first metallization layer 111, wherein the first section and the second section of the first metallization layer 111 have no direct electrical connection. A size of each of the connection areas may be small as compared to the size of the substrate 10.

Directing a laser beam 80 to the soldering or sintering pre-layer 32, thereby heating the soldering or sintering pre-layer 32 may comprise heating the soldering or sintering pre-layer 32 up to a soldering or sintering temperature at which the soldering or sintering pre-layer 32 softens or melts. After softening or melting the soldering or sintering pre-layer 32 by means of the laser beam 80, the softened or melted soldering or sintering pre-layer 32 may be cooled down, thereby forming a permanent connection (electrically conductive connection layer 30) between the passive component 22 and the substrate 10.

When, e.g., a soldering or sintering paste is applied to a substrate 10 to form the soldering or sintering pre-layer 32, this is generally a wet soldering or sintering paste, comprising a certain amount of liquid (as compared to, e.g., a powder or a preform which are usually dry). A passive component 22 may be applied directly on a wet soldering or sintering pre-layer 32. In a subsequent step, some of the liquid may be removed from the soldering or sintering pre-layer 32, before the laser beam 80 is directed on the soldering or sintering pre-layer 32. This, however, is optional. The laser beam 80 may also be directed on the still wet soldering or sintering pre-layer 32.

According to another example, a wet soldering or sintering paste is applied to the substrate 10, and the soldering or sintering paste is then cured to a certain degree by removing liquid from the wet soldering or sintering paste to form the soldering or sintering pre-layer 32. The passive component 22 may then be arranged on the cured and comparably dry soldering or sintering paste, from which a certain amount of liquid has been removed. Optionally, it is possible to apply an adhesion promoter to the cured soldering or sintering paste (the pre-layer 32) before arranging the passive component 22 thereon. Subsequently, the laser beam 80 may be directed to the soldering or sintering pre-layer 32, with the passive component 22 (and optionally the adhesion promoter) arranged thereon.

The described methods provide several advantages. For example, no dedicated sinter tools are required to form the permanent connection between the passive component 22 and the substrate 10. Therefore, it is not necessary to arrange different components of the power semiconductor module arrangement 100 on the substrate in a way that provides a large enough open space to allow a sinter tool to reach the passive component 22. Further, for the same reasons, passive components 22 may be permanently attached to the substrate 10 at any point during the assembly process of the power semiconductor module arrangement 100. There is no need to consider any specific sequence of the assembly steps (e.g., to allow a large enough open space for any conventional sinter tools). Any differences in height of different elements (e.g., different sections of the first metallization layer 11, different sections of a soldering or sintering pre-layer 32, etc.) do not have a substantial impact on the method or the resulting electrically conductive connection layers 30.

## Claims

1. A method comprises,
applying a soldering or sintering pre-layer (32) to a substrate (10);
arranging a passive component (22) on the soldering or sintering pre-layer (32); and
directing a laser beam (80) to the soldering or sintering pre-layer (32), thereby heating the soldering or sintering pre-layer (32).

2. The method of claim 1, wherein applying the soldering or sintering pre-layer (32) comprises applying the soldering or sintering pre-layer (32) on at least two dedicated connection areas of the substrate (10), wherein the at least two dedicated connection areas are separate and distinct from each other.

3. The method of claim 1 or 2, wherein applying the soldering or sintering pre-layer (32) to a substrate (10) comprises applying the soldering or sintering pre-layer (32) to a substrate (10) comprising a dielectric insulation layer (11) and a first metallization layer (111) arranged on a first surface of the dielectric insulation layer (11).

4. The method of claim 3, wherein applying the soldering or sintering pre-layer (32) to a substrate (10) comprising a dielectric insulation layer (11) and a first metallization layer (111) arranged on a first surface of the dielectric insulation layer (11) comprises applying the soldering or sintering pre-layer (32) to a substrate (10) comprising a ceramic dielectric insulation layer (11).

5. The method of claim 3 or 4, wherein applying the soldering or sintering pre-layer (32) to a substrate (10) comprising a dielectric insulation layer (11) and a first metallization layer (111) arranged on a first surface of the dielectric insulation layer (11) comprises applying the soldering or sintering pre-layer (32) to the first metallization layer (111).

6. The method of any of the preceding claims, wherein applying the soldering or sintering pre-layer (32) to a substrate (10) comprises applying a soldering or sintering paste or powder, or a solder or sinter preform to the substrate (10).

7. The method of any of the preceding claims, wherein applying the soldering or sintering pre-layer (32) to a substrate (10) comprises applying a powdery, liquid, viscous or solid soldering or sintering pre-layer (32) to the substrate (10).

8. The method of any of the preceding claims, wherein applying the soldering or sintering pre-layer (32) to a substrate (10) comprises applying a soldering or sintering pre-layer (32) comprising or consisting of silver, copper, zinc, a silver alloy, a copper alloy, or a zinc alloy.

9. The method of any of the preceding claims, wherein arranging a passive component (22) on the soldering or sintering pre-layer (32) comprises arranging a resistor, a capacitor, a shunt, or an inductor on the soldering or sintering pre-layer (32).

10. The method of any of the preceding claims, wherein directing a laser beam (80) to the soldering or sintering pre-layer (32), thereby heating the soldering or sintering pre-layer (32), comprises heating the soldering or sintering pre-layer (32) up to a soldering or sintering temperature at which the soldering or sintering pre-layer (32) softens or melts.

11. The method of claim 10, further comprising
after softening or melting the soldering or sintering pre-layer (32) by means of the laser beam (80), cooling down the softened or melted soldering or sintering pre-layer (32), thereby forming a permanent connection between the passive component (22) and the substrate (10).

12. The method of any of the preceding claims, further comprising
holding the passive component (22) in a desired position by means of a holding mechanism while directing a laser beam (80) to the soldering or sintering pre-layer (32).

13. The method of claim 12, comprising applying a force (F_{H}) on the passive component (22) by means of the holding mechanism, the force (F_{H}) causing the passive component (22) to sink into the soldering or sintering pre-layer (32) towards the substrate (10).

14. The method of any of the preceding claims, the method comprising
applying a wet soldering or sintering paste to a substrate (10) to form the soldering or sintering pre-layer (32); and
arranging a passive component (22) on the wet soldering or sintering paste.

15. The method of any of claims 1 to 13, the method comprising
applying a wet soldering or sintering paste to a substrate (10);
curing the soldering or sintering paste by removing liquid from the wet soldering or sintering paste to form the soldering or sintering pre-layer (32); and
arranging a passive component (22) on the cured soldering or sintering paste.
